# EUROPÄISCHE PATENTSCHRIFT

(11) **EP 1 214 869 B1**
(45) Veröffentlichungstag und Bekanntmachung des Hinweises auf die Patenterteilung: **02.04.2003**
(21) Anmeldenummer: 00958286.7
(22) Anmeldetag: 22.07.2000
(51) Int. Cl.: H05K 7/20, F24F 1/02

(54) **SCHALTGEHÄUSE**
SHIFT-CONTROL HOUSING
COFFRET DE COMMANDE

(30) Priorität: 11.09.1999 DE 19943530
(43) Veröffentlichungstag der Anmeldung: 19.06.2002
(73) Patentinhaber: Rittal-Werk Rudolf Loh GmbH & Co. KG, 35745 Herborn (DE)
(72) Erfinder: NICOLAI, Walter, D-35418 Buseck 1 (DE); PAWLOWSKI, Adam, D-73760 Stuttgart (DE)
(74) Vertreter: Fleck, Hermann-Josef, Dr.-Ing.
(86) Internationale Anmeldenummer: EP0007046
(87) Internationale Veröffentlichungsnummer: WO01020959

(56) Entgegenhaltungen:
- WO-A-99/65284
- DE-A- 3 504 207
- DE-A- 19 701 100
- DE-C- 19 709 145
- DE-U- 9 112 958

## Beschreibung

Die Erfindung betrifft ein Schaltgehäuse, beispielweise Schaltschrank mit einem Gehäusekorpus, der im Bereich einer Seitenwand eine Klimatisierungs-Einrichtung mit einem Wärmetauscher aufweist, wobei an dem Wärmetauscher wenigstens ein Lüfter befestigt ist, der Luft aus dem Schaltgehäuse-Innenraum in Innen-Luftführungskanäle des Wärmetauschers fördert.

Ein solches Schaltgehäuse in Form eines Schaltschrankes ist aus der FR 2 193 303 bekannt. Dieser Schaltschrank weist doppelwandige Seitenwände auf, in denen jeweils bodenseitig ein Lüfter untergebracht ist. Die dem Schaltschrank-Innenraum zugekehrte Wandung der Seitenwand ist mit Luftdurchtritts-Öffnungen versehen. Der Lüfter fördert Luft in den Innen-Luftführungskanal, die dann aus den Luftdurchtritts-Öffnungen heraus an bestimmte, zu kühlende Zonen des Schaltschrankes abgegeben wird.

Die Kühlleistung solcher Klimatisierungs-Einrichtungen ist sehr begrenzt.

Aus der DE 195 31 310 A1 ist eine Klimatisierungs-Einrichtung bekannt, die anstelle einer Seitenwand an das Rahmengestell eines Schaltschrankes ange-baut werden kann. Die Klimatisierungs-Einrichtung weist einen Luft-Luft-Wärmetauscher auf, der mittels zweier Hauben gekappselt werden kann. Der Wärmetauscher weist Innen-Luftführungskanäle auf, die dem Schaltschrank-Innenraum zugekehrt sind und aussenseitige Aussen-Luftführungskanäle auf-weisen. Die Innen-Luftführungskanäle bilden zusammen mit der zugeordneten Haube den Innenkreislauf. Dementsprechend bildet die aussenseitige Haube mit den Aussen-Luftführungskanälen den Aussenkreislauf. Jeder der Hauben ist ein Lüfter zugeordnet, der Luft durch die entsprechenden Luftführungskanäle fördert. Derartige Klimatisierungs-Einrichtungen sind fest auf eine bestimmte Kühlleistung ausgelegt.

Es ist Aufgabe der Erfindung, ein Schaltgehäuse der eingangs erwähnten Art zu schaffen, das einen einfachen Aufbau aufweist und das sich auf unterschiedliche Kühlleistungen auslegen lässt.

Diese Aufgabe wird dadurch gelöst, dass der Wärmetauscher als Luft-Luft-Wärmetauscher ausgebildet ist, der räumlich von den Innen-Luftführungskanälen getrennte Aussen-Luftführungskanäle aufweist, und dass der Wärmetauscher im Bereich der längsseitigen Enden der Aussen- und Innen-Luftführungskanäle Endabschnitte aufweist, an denen Ansatzgehäuse befestigbar sind, an denen die Lüfter gehalten sind.

Der Wärmetauscher kann als Einhait auf die gewünschte Kühlleistung ausgelegt werden und wird dann mit den Ansatzgehäusen komplettiert. Für geringe Kühlleistungen kann beispielsweise auch nur ein Ansatzgehäuse Verwendung finden, das dann dem Schaltgehäuse-Innenraum zugekehrt ist.

Nach einer bevorzugten Ausgestaltungsvariante der Erfindung ist es vor-gesehen, dass die Ansatzgehäuse, die den Aussen-und Innen-Luftführungs-kanälen zugeordnet sind, baugleich sind. Mit dieser Massnahme kann der Teileaufwand gering gehalten werden.

Damit für den Wärmetauscher eine geringe Bautiefe verwirklicht werden kann, ist es vorgesehen, dass der Wärmetauscher in Luft-Strömungsrichtung verlaufende Lamellen aufweist, die die Innen-Luftführungskanäle von den Aussen-Luftführungskanälen trennen, dass die Aussen-Luftführungskanäle einseitig von der Seitenwand des Gehäusekorpusses und die Innen-Luftführungskanäle von einer, dem Schaltgehäuse-Innenraum zugewandten Abdeckung abgedeckt sind,

Dadurch, dass die Seitenwand mit in den Wärmetauscher intergriert ist, lässt sich zum einen der Teileaufwand reduzieren. Zum anderen kann über die Seitenwand hinweg auch grossflächig ein Wärmetausch mit der Umgebung erfolgen.

In dem Schaltgehäuse sind üblicherwiese elektrische Einheiten installiert. Damti nun die Klimatisierungs-Einrichtung auf die räumlichen Gegebenheiten im Schaltschrank-Innenraum angepasst werden kann, ist es vorgesehen, dass das Ansatzgehäuse quer zur Luftführungsrichtung und in einer parallel zur Seitenwandebene verlaufende Richtung gegenüber dem Wärmetauscher versetzbar ist.

Nach einer möglichen Erfindungsvariante kann es vorgesehen sein, dass das Ansatzgehäuse einen Tragabschnitt aufweist, an dem der Lüfter derart befestigt ist, dass das Lüfterrad des Lüfters in dem von dem Ansatzgehäuse umgebenen Aufnahmeraum gehalten ist, und der Lüftermotor dem Aufnahmeraum abgekehrt über den Tragabschnitt vorsteht, und dass das Ansatzgehäuse wahlweise so an der Seitenwand anbaubar ist, dass der Lüftermotor in den Schaltgehäuse-Innenraum oder aussenseitig über die Seitenwand ragt. Hierbei lässt sich ein Ansatzgehäuse mit kleiner Baugrösse ausbilden. Die wahlweise Zurodnung des Lüftermotors entweder im Schaltgehäuse-Innenraum oder an der Schaltgehäuse-Aussenseite ermöglicht mehrere Bauvarianten.

Bevorzugterweise ist ein Schaltgehäuse derart konzipiert, dass die Seitenwand an einem Rahmengestell angebracht ist, das aus horizontalen und vertikalen Rahmenprofilen zusammengesetzt ist, und dass der Wärmetauscher nicht über die vertikalen Rahmenprofile hinaus in den Schaltschrank-Innenraum vorsteht. Mit dieser Erfindungsvariante werden die Einbauverhältnisse im Schaltgehäuse-Innenraum nicht oder nur geringfügig beeinträchtigt.

Die Erfindung wird im Folgenden anhand von in den Zeichnungen dargestellten Ausführungsbeispielen näher erläutert. Es zeigen:
- Fig. 1: Eine Seitenwand eines Schaltgehäuses mit angebauter Klimatisierungs-Einrichtung in perspektivischer Seiten-ansicht,
- Fig. 2: eine Seitenwand eines als Kleingehäuse ausgebildeten Schaltgehäuses mit angebauter Klimatisierungs-Einrichtung in perspektivischer Seitenansicht,
- Fig. 3: einen Wärmetauscher im Horizontalschnitt und Teildarstellungen,
- Fig. 4: eine Seitenwand eines Schaltgehäuses mit angebauter Klimatisierungs-Einrichtung in Frontansicht,
- Fig. 5: die Darstellung gem. Fig. 4 jedoch mit umgebauter Klimatisierungs-Einrichtung in Seitenansicht und im Schnitt,
- Fig. 6: die Darstellung gem. Fig. 4 jedoch mit umgebauter Klimatisierungs-Einrichtung in Seitenansicht und im Schnitt und
- Fig. 7: die Darstellung gem. Fig. 4 ein Seitenansicht und im Schnitt.

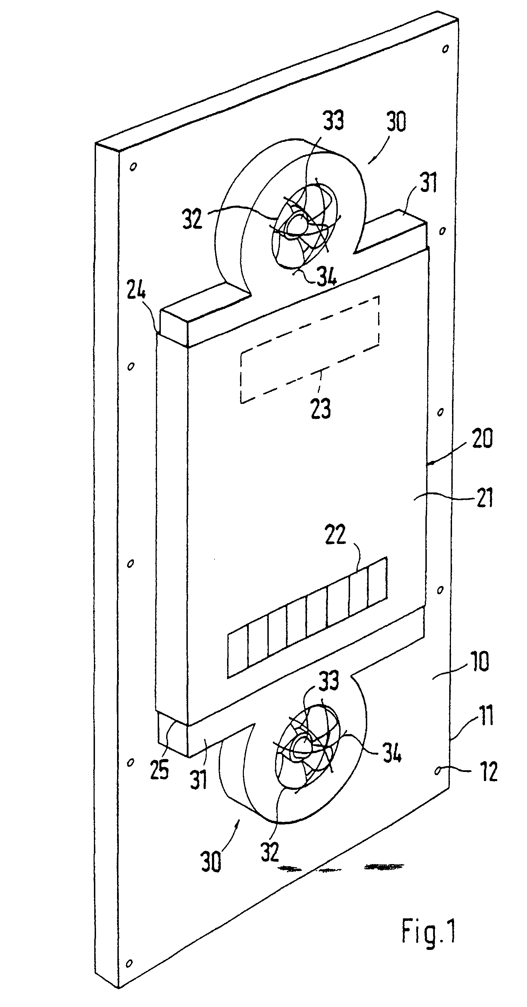

In der Fig. 1 ist eine Klimatisierungs-Einrichtung gezeigt, die an eine Seitenwand 10 eines als Schaltschrank ausgebildeten Schaltgehäuses angebaut werden kann. Die Seitenwand 10 ist aus einem Stahlblechzuschnitt gefertigt und besitzt einen seitlichen umlaufend abgekanteten Rand 11. Im Bereich dieses Randes 11 ist die Seitenwand 10 auch mit Befestigungsaufnahmen 12 versehen, mittels derer sie sich an einem Rahmengestell des Schaltschrankes befestigen lässt.

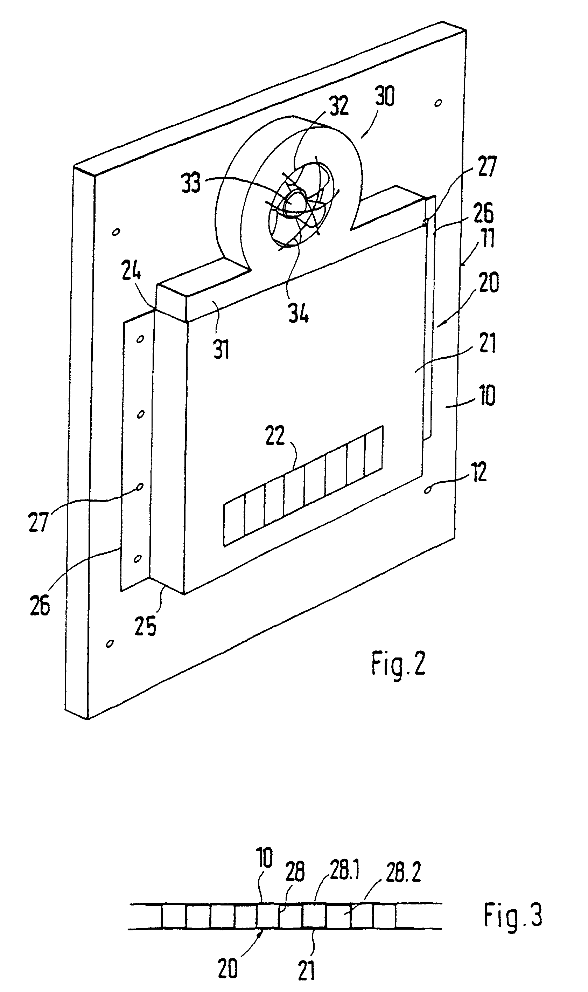

Auf der dem Schaltschrank-Innenraum zugekehrten Innenseite ist an der Seitenwand 10 eine Klinatisierungs-Einrichtung befestigt. Die Klimatisierungs-Einrichtung besitzt einen Wärmetauscher 20. Der Aufbau des Wärmetauschers 20 lässt sich im Einzelenn näher an der Fig. 3 erkennen, die einen Wärme-tauschabschnitt im Horizontalschnitt zeigt. Wie die Fig. 3 erkennen lässt, weist der Wärmetauscher 20 ein Lamellenblech 28 auf, das vielfach gebogen ist, um im Querschnitt z.B. quadratische oder rechteckförmige Innen- und Aussen-Luft-führungskanäle 28.1, 28.2 zu bilden. Die Aussen-Luftführungskanäle 28.1 werden dabei von einer Abdeckung 21 begrenzt, die den Wärmetauscher 20 innenseitig überdeckt. Die Innen-Luftführungskanäle 28.2 werden mit der Seitenwand 10 abgeschlossen.

Wie die Fig. 1 weiter erkennen lässt, überdeckt die Abdeckung 21 auch mit Seitenteilen, die vertikal zur Seitenwand 10 ausgerichtet sind, die Wärmetauscherseiten.

Im Bereich des oberen und unteren Endes des Wärmetauschers 20 sind Endabschnitte 24, 25 vorgesehen, an denen Ansatzgehäuse 30 befestigt werden können. Hierzu besitzt das Ansatzgehäuse 30 einen Befestigungsabschnitt 31. In dem Ansatzgehäuse 30 ist mindestens ein Lüfter 33 untergebracht. Dieser fördert Luft durch eine Durchtrittsöffnung 32 des Ansatzgehäuses 30. Der obere Lüfter 33 ist dem Innenraum, der untere Lüfter 33 der Umgebung des Schaltgehäuses zugeordnet.

Während des Betriebes der Klimatisierungs-Einrichtung wird von dem obenliegenden Lüfter 33 Luft aus dem Schaltgehäuse-Innenraum durch die Durchtrittsöffnungen 32 hindurch abgesaugt und in den Wärmetauscher 20 hinein gefördert. Die Luft durchströnmt die Innen-Luftführungskanäle 28.2 wobei Wärmeenergie über die Wandungen des Lamellenbleches 28 in die Aussen-Luftführungskanäle 28.1 hinein übertragen wird. Gleichzeitig wird auch Wärmeenergie direkt über die Seitenwand 10 an die Umgebung abgegeben. Die klimatisierte Luft kann über Luftdurchführungs-Öffnungen 22 der Abdeckung 24 wieder in den Schaltschrank-Innenraum abgegeben werden.

Der untere Lüfter 32 saugt Umgebungsluft durch die der Umgebung zugeordnete Durchtrittsöffnung 32 an und fördert diese in die Aussen-Luftführungskanäle 28.1. Diese Umgebungsluft nimmt die aus den Innen-Luftführungskanälen 28.2 abgegebene Wärme auf und transportiert sie ab. Die so erwärmte Luft wird dann wieder über eine Luftdurchtritts-Öffnung 23 der Umgebung zugeleitet. Damit ist ein Luft-Luft-Wärmetauscher 20 geschaffen, der im Gegenstromprinzip betrieben wird. Denkbar ist es auch, die Strömungs-richtungen so zu führen, dass ein Gleichstromprinzip oder auch Kreuzstrom-prinzip verwirklicht ist.

Die Lüfter 33 und gegenbenfalls auch die den Lüfter 33 antreibenden Lüftermotoren sind mittels eines Berührschutzes 33 abgedeckt.

In der Fig. 2 ist eine Klimatisierungs-Einrichtung gezeigt, die gegenüber der Klimatisierungs-Einrichtung gemäß Fig. 1 für kleinere Kälteleistungen ausgelegt ist. Dabei entspricht der Aufbau des Wärmetauschers 20 im Wesentlichen der Gestaltung gemäß Fig. 1. Ein Unterschied besteht dahingehend, dass die Abdeckung 21 mit seitlichen Flanschen 26 versehen ist. Über Befestigungspunkte 27 der Flansche 26 ist der Wärmetauscher 20 an der Seitenwand 10 gehalten. Bei der vorliegenden Klimatisierungs-Einrichtung ist nur an dem oberen Endabschnitt 24 ein Ansatzgehhäuse 30 mit Lüfter 33 angebaut. Mittels dieses Lüfters 33 wird die Luft des Schaltschrank-Innenraumes umgewälzt. Die Wärmeabgabe erfolgt über die Seitenwand 10.

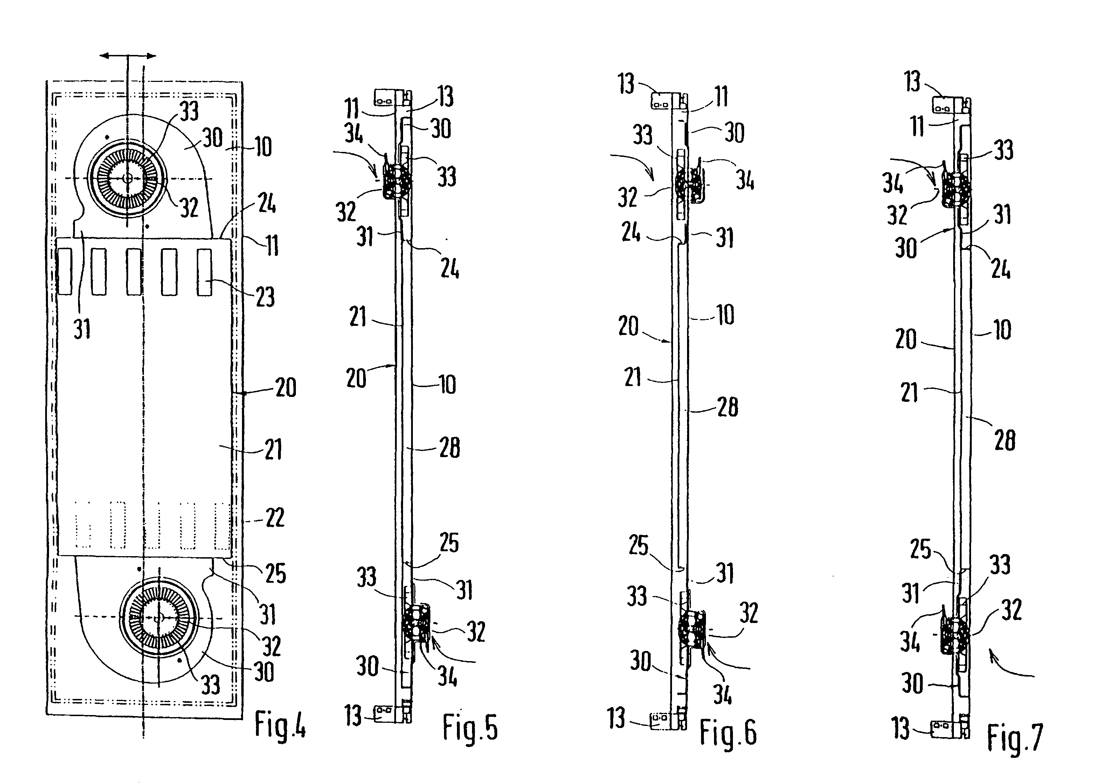

In den Fig. 4 bis 7 ist eine weitere Ausgestaltungsvariante einer Klima-tisierungs-Einrichtung gezeigt. Dabei können die beiden Ansatzgehäuse 30 mittels Führungselementen in horizontaler Richtung verstellt werden, wie dies der Doppelpfeil veranschaulicht. Infolge dieser Versatzmöglichkeit kann das Ansatzgehäuse 30 Einbauten, die im Innenraum des Schaltschrankes gehalten sind, ausweichen.

In den Fig. 5 bis 7 sind verschiedene Möglichkeiten zur Anordnung des Lüfters 33 gezeigt. Der Lüfter 33 ist an einem Befestigungsabschnitt des Ansatzgehäuses 30 angeflanscht, wobei der Lüftermotor aussenseitig am Anatzgehäuse 30 vorsteht. Das Lüfterrad des Lüfters 33 ist dem Innenraum des Ansatzgehäuses 30 zugeordnet. Wie die einzelnen Ausführungsvarianten nun zeigen, kann das Ansatzgehäuse 30 wahlweise so angebaut sein, dass der Lüftermotor entweder in den Schaltschrank-Innenraum oder in die Umgebung ragt.

Aus den Seitenansichten gem. Fig. 5 bis 7 lässt sich auch ersehen, dass der Wärmetauscher 20 und die Ansatzgehäuse 30 nicht über die vertikalen Rahmenprofile 13 des Rahmengestelles des Schaltschrankes hinweg in den Schaltschrank-Innenraum vorstehen. Mit dieser Bauweise wird verhindert, dass die Klimatisierungs-Einrichtung Einbaumöglichkeiten im Schaltschrank-Innenraum blockiert.

## Patentansprüche

1. Schaltgehäuse, beispielweise Schaltschrank mit einem Gehäusekorpus der im Bereich einer Seitenwand eine Klimatisierungs-Einrichtung mit einem Wärmetauscher aufweist, wobei an dem Wärmetauscher wenigstens ein Lüfter befestigt ist, der Luft aus dem Schaltgehäuse-Innenraum in Innen-Luftführungskanäle des Wärmetauschers fördert,
**dadurch gekennzeichnet,**
**dass** der Wärmetauscher (20) als Luft-Luft-Wärmetauscher ausgebildet ist, der räumlich von den Innen-Luftführungskanälen (28.2) getrennte Aussen-Luftführungskanäle (28.1) aufweist, und
**dass** der Wärmetauscher im Bereich der längsseitigen Enden der Aussen-und Innen-Luftführungskanäle (28.1, 28.2) Endabschnitte (24, 25) aufweist, an denen Ansatzgehäuse (30) befestigbar sind, an denen die Lüfter (33) gehalten sind.

2. Schaltgehäuse nach Anspruch 1,
**dadurch gekennzeichnet,**
**dass** die Ansatzgehäuse (30), die den Aussen-und Innen-Luftführungskanälen (28.1, 28.2) zugeordnet sind, baugleich sind.

3. Schaltgehäuse nach Anspruch 1 oder 2,
**dadurch gekennzeichnet,**
**dass** der Wärmetauscher (20) in Luft-Strömungsrichtung verlaufende Lamellen (28) aufweist, die die Innen-Luftführungskanäle (28.2) von den Aussen-Luftführungskanälen (28.1) trennen,
**dass** die Aussen-Luftführungskanäle (28.1) einseitig von der Seitenwand (10) des Gehäusekorpusses und die Innen-Luftführungskanäle (28.2) von einer, dem Schaltgehäuse-Innenraum zugewandten Abdeckung (21) abgedeckt sind.

4. Schaltgehäuse nach Anspruch 3,
**dadurch gekennzeichnet,**
**dass** die Lamellen (28) des Wärmetauschers (20) von einem Lamellen-blech gebildet sind, wobei die Innen-Luftführungskanäle (28.2) an ihrem der Seitenwand (10) zugewandten Bereich und die Aussen-Luftführungskanäle (28.1) an ihrem den Schaltgehäuse-Innenraum zugekehrten Bereich mit Blechabschnitten des Lamellenbleches verschlossen sind.

5. Schaltgehäuse nach einem der Ansprüche 1 bis 4,
**dadurch gekennzeichnet,**
**dass** das Ansatzgehäuse (30) quer zur Luftführungsrichtung und in einer parallel zur Seitenwandebene verlaufende Richtung gegenüber dem Wärmetauscher (20) versetzbar ist.

6. Schaltgehäuse nach einem der Ansprüche 1 bis 5,
**dadurch gekennzeichnet,**
**dass** das Ansatzgehäuse (30) einen Tragabschnitt aufweist, an dem der Lüfter (33) derart befestigt ist, dass das Lüfterrad des Lüfters (33) in dem von dem Ansatzgehäuse (30) umgebenen Aufnahmeraum gehalten ist, und der Lüftermotor dem Aufnahmeraum abgekehrt über den Tragabschnitt vorsteht, und
**dass** das Ansatzgehäuse (30) wahlweise so an der Seitenwand (10) anbaubar ist, dass der Lüftermotor in den Schaltgehäuse-Innenraum oder aussenseitig über die Seitenwand (10) ragt.

7. Schaltgehäuse nach einem der Ansprüche 1 bis 6,
**dadurch gekennzeichnet,**
**dass** die Seitenwand (10) an einem Rahmengestell (13) angebracht ist, das aus horizontalen und vertikalen Rahmenprofilen zusammengesetzt ist, und dass der Wärmetauscher (20) nicht über die vertikalen Rahmenprofile hinaus in den Schaltschrank-Innenraum vorsteht.

## Claims

1. Switch housing, for example switch cabinet, having a basic housing structure which, in the region of a side wall, has a climate-control device with a heat exchanger, at least one fan being fastened on the heat exchanger, and said fan conveying the air from the interior of the switch housing into inner air-channelling ducts of the heat exchanger, **characterized in that** the heat exchanger (20) is designed as an air/air heat exchanger which has outer air-channelling ducts (28.1) which are spatially separated from the inner air-channelling ducts (28.2), and **in that**, in the region of the longitudinal ends of the outer and inner air-channelling ducts (28.1, 28.2), the heat exchanger has end sections (24, 25) on which it is possible to fasten add-on housings (30), on which the fans (33) are retained.

2. Switch housing according to Claim 1, **characterized in that** the add-on housings (30), which are assigned to the outer and inner air-channelling ducts (28.1, 28.2), are of identical construction.

3. Switch housing according to Claim 1 or 2, **characterized in that** the heat exchanger (20) has lamellae (28) which run in the air-flow direction and separate the inner air-channelling ducts (28.2) from the outer air-channelling ducts (28.1), and **in that** the outer air-channelling ducts (28.1) are covered on one side by the side wall (10) of the basic housing structure and the inner air-channelling ducts (28.2) are covered by a covering (21) which is directed towards the interior of the switch housing.

4. Switch housing according to Claim 3, **characterized in that** the lamellae (28) of the heat exchanger (20) are formed by a lamella plate, the inner air-channelling ducts (28.2) being closed by sections of the lamella plate at their region which is directed towards the side wall (10), and the outer air-channelling ducts (28.1) being closed by sections of the lamella plate at their region which is directed towards the interior of the switch housing.

5. Switch housing according to one of Claims 1 to 4, **characterized in that** the add-on housing (30) can be shifted in relation to the heat exchanger (20) in a direction transverse to the air-channelling direction and in a direction running parallel to the side-wall plane.

6. Switch housing according to one of Claims 1 to 5, **characterized in that** the add-on housing (30) has a carrying section on which the fan (33) is fastened such that the impeller of the fan (33) is retained in the accommodating space enclosed by the add-on housing (30), and the fan motor, in the direction facing away from the accommodating space, projects beyond the carrying section, and **in that** the add-on housing (30) can optionally be fitted on the side wall (10) such that the fan motor projects into the interior of the switch housing or beyond the side wall (10) on the outside.

7. Switch housing according to one of Claims 1 to 6, **characterized in that** the side wall (10) is fitted on a framework (13) which is made up of horizontal and vertical frame profiles, and **in that** the heat exchanger (20) does not project beyond the vertical frame profiles into the interior of the switch cabinet.

## Revendications

1. Coffret de commande, en particulier armoire de commande avec un corps de coffret qui présente dans la région d'une paroi latérale un dispositif de climatisation avec un échangeur de chaleur, dans lequel au moins un ventilateur est fixé à l'échangeur de chaleur, qui refoule de l'air hors de l'espace intérieur du coffret de commande dans des canaux internes de guidage d'air de l'échangeur de chaleur, **caractérisé en ce que** l'échangeur de chaleur (20) se présente comme un échangeur de chaleur air-air, qui présente des canaux externes de guidage d'air (28.1) spatialement séparés des canaux internes de guidage d'air (28.2), et **en ce que** l'échangeur de chaleur présente dans la région des extrémités longitudinales des canaux externes et internes de guidage d'air (28.1, 28.2) des parties d'extrémité (24, 25), auxquelles peuvent être fixés des boîtiers appliqués (30), sur lesquels les ventilateurs (33) sont maintenus.

2. Coffret de commande suivant la revendication 1, **caractérisé en ce que** les boîtiers appliqués (30), qui sont associés aux canaux externes et internes de guidage d'air (28.1, 28.2), sont de construction identique.

3. Coffret de commande suivant la revendication 1 ou 2, **caractérisé en ce que** l'échangeur de chaleur (20) présente des lamelles (28) orientées dans le sens de l'écoulement de l'air, qui séparent les canaux internes de guidage d'air (28.2) des canaux externes de guidage d'air (28.1), et **en ce que** les canaux externes de guidage d'air (28.1) sont recouverts d'un côté par la paroi latérale (10) du corps de coffret et les canaux internes de guidage d'air (28.2) sont recouverts par un couvercle (21) tourné vers l'espace intérieur du coffret de commande.

4. Coffret de commande suivant la revendication 3, **caractérisé en ce que** les lamelles (28) de l'échangeur de chaleur (20) sont formées par une tôle à lamelles, dans lequel les canaux internes de guidage d'air (28.2) sont fermés dans leur région tournée vers la paroi latérale (10) et les canaux externes de guidage d'air (28.1) sont fermés dans leur région tournée vers l'espace intérieur du coffret de commande avec des parties de tôle de la tôle à lamelles.

5. Coffret de commande suivant l'une quelconque des revendications 1 à 4, **caractérisé en ce que** le boîtier appliqué (30) peut être déplacé transversalement au sens de guidage de l'air et dans une direction orientée parallèlement au plan de la paroi latérale, par rapport à l'échangeur de chaleur (20).

6. Coffret de commande suivant l'une quelconque des revendications 1 à 5, **caractérisé en ce que** le boîtier appliqué (30) présente une partie portante, sur laquelle le ventilateur (33) est fixé de telle manière que la roue du ventilateur (33) soit maintenue dans l'espace de logement entouré par le boîtier appliqué (30), et que le moteur du ventilateur déborde au-delà de la partie portante à l'opposé de l'espace de logement, et **en ce que** le boîtier appliqué (30) peut être monté au choix sur la paroi latérale (10) de telle manière que le moteur du ventilateur pénètre dans l'espace intérieur du coffret de commande ou sorte du côté extérieur au-delà de la paroi latérale (10).

7. Coffret de commande suivant l'une quelconque des revendications 1 à 6, **caractérisé en ce que** la paroi latérale (10) est installée sur un cadre de châssis (13), qui est composé de profilés de cadre horizontaux et verticaux, et **en ce que** l'échangeur de chaleur (20) ne déborde pas au-delà des profilés de cadre verticaux dans l'espace intérieur de l'armoire de commande.
